(19) Europäisches Patentamt
European Patent Office
Office européen des brevets

(11) **EP 4 621 782 A1**

(12) **EUROPEAN PATENT APPLICATION**

(43) Date of publication:
24.09.2025 Bulletin 2025/39

(21) Application number: 25165156.8

(22) Date of filing: 20.03.2025

(51) International Patent Classification (IPC):
*G11C 11/39* (2006.01)      *G06N 3/063* (2023.01)
*G11C 11/54* (2006.01)

(52) Cooperative Patent Classification (CPC):
G11C 11/39; G06N 3/045; G06N 3/048;
G06N 3/049; G06N 3/063; G06N 3/065; G06N 3/08;
G11C 11/54

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 22.03.2024 KR 20240039833

(71) Applicant: Korea University Research and
Business Foundation
Seoul 02841 (KR)

(72) Inventors:
• KIM, Sang Sig
06277 Seoul (KR)
• CHO, Kyoung Ah
04989 Seoul (KR)
• SHIN, Yun Woo
14207 Gwangmyeong-si, Gyeonggi-do (KR)
• JEON, Ju Hee
03773 Seoul (KR)

(74) Representative: Prüfer & Partner mbB
Patentanwälte · Rechtsanwälte
Sohnckestraße 12
81479 München (DE)

(54) **BINARIZED NEURAL NETWORK CIRCUITRY USING QUASI-NONVOLATILE MEMORY DEVICE**

(57)     Disclosed is a binarized neural network circuitry using a quasi-nonvolatile memory device. More particularly, the binarized neural network circuitry according to an embodiment of the present disclosure is characterized in that a diode structure is positioned in a channel region between a drain terminal and a source terminal, a gate terminal is positioned on the diode structure, an operation state is determined by occurrence of a latch-up or latch-down phenomenon due to a positive feedback loop in the channel region based on different voltages applied to the drain terminal and the gate terminal, respectively, and a plurality of quasi-nonvolatile memory devices that implement memory characteristics of remembering a memory state are included as holes or electrons in a potential well in the channel region due to the positive feedback loop are accumulated, and the plural quasi-nonvolatile memory devices are a pair of two quasi-nonvolatile memory devices that operate as a single synaptic cell and are connected in parallel to form an array circuit, memory states of the two quasi-nonvolatile memory devices are determined and stored based on an input line applied from an input line processor connected to the array circuit and a weight update signal applied from a synaptic line processor connected to the array circuit, and a MAC (multiply-accumulate) operation result is output using a combination of the memory states.

【FIG. 3】

EP 4 621 782 A1

## Description

CROSS-REFERENCE TO RELATED APPLICATION

This application claims priority to Korean Patent Application No. 10-2024-0039833, filed on March 22, 2024 in the Korean Intellectual Property Office, the disclosure of which is incorporated herein by reference.

## BACKGROUND OF THE DISCLOSURE

### Field of the Disclosure

The present disclosure relates to a binarized neural network circuitry using a quasi-nonvolatile memory (QNVM) device, and more particularly to a technology for implementing a binarized neural network that can perform both memory functions and logical operation functions in a memory array consisting of a quasi-nonvolatile memory device that performs memory and switching functions in a single device based on a positive feedback loop.

### Description of the Related Art

In the existing von Neumann-based computer system, processor and memory are separated so that data signals are transmitted through bus lines.

However, as computing performance increased, bottlenecks occurred due to a difference in data processing speeds between processor and memory, and limitations began to appear in processing large amounts of data.

In other words, the von Neumann-based system, a revolutionary development in the semiconductor industry, improved the integration density and performance of modern computers, but it is disadvantageous in that energy consumption is high and data transmission and latency are long due to the physical separation between the processor and memory hierarchy.

Given the rise of data-intensive applications such as 5G communication standards, Internet Of Things (IoT), and Artificial Intelligence (AI) following the 4th Industrial Revolution, a new computing paradigm is essential to meet massive data processing requirements.

To solve the problems mentioned above, research on Logic In Memory (LIM) technology that combines computational and memory functions is being focused and accelerated.

The LIM technology performs the computational function of the processor and the storage function of the memory in the same space, which reduces the delay time and power consumption that occurs during data transmission and dramatically improves the integration of the system.

Conventionally, the LIM technology has been actively studied based on volatile memory devices such as Static Random Access Memory (SRAM), Dynamic RAM (DRAM), and nonvolatile memory devices such as Resistive RAM (ReRAM), Magnetoresistive RAM (MRAM), and Phase-Change RAM (PCRAM).

To overcome the limitations of large-capacity data processing, Package On Package (POP) and Through Silicon Via (TSV) technologies that integrate logic memory into a single chip are being studied, but since logic and memory functions are not performed simultaneously in transistors, bottlenecks, power consumption, computational efficiency, and integration problems still exist.

In addition, the LIM technology based on nonvolatile memory devices requires a complex process due to the use of non-silicon materials, and is difficult to commercialize due to low device uniformity and stability.

In addition, the LIM technologies studied so far cannot implement all basic Complementary Metal-Oxide Semiconductor (CMOS) logic operations in a single cell, and have low integration because individual circuits and wiring are required depending on logic operations.

Therefore, it is necessary to develop a binarized neural network technology that utilizes a quasi-nonvolatile memory device that can be applied to the CMOS process and performs switching and memory functions simultaneously, and a self-activating neural network technology that performs the activation function of the neuron circuit in the neural network on its own.

[Related Art Documents]

[Patent Documents]

Korean Patent Application Publication No. 10-2023-0053195, entitled "STATEFUL LOGIC-IN-MEMORY ARRAY USING SILICON DIODES"

Korean Patent Application Publication No. 10-2022-0110774, entitled "PERFORMANCE AND AREA EFFICIENT SYNAPSE MEMORY CELL STRUCTURE"

Korean Patent Application Publication No. 10-2023-0020840, entitled "RECONFIGURABLE LOGIC-IN-MEMORY DEVICE USING SILICON TRANSISTOR"

Korean Patent Application Publication No. 10-2022-0107808, entitled "A MIXED-SIGNAL BINARIZED NEURAL NETWORK CIRCUIT DEVICE"

## SUMMARY OF THE DISCLOSURE

Therefore, the present disclosure has been made in view of the above problems, and it is an object of the present disclosure to implement a binarized neural network that can perform both memory functions and logical operation functions on a memory array consisting of quasi-nonvolatile memory devices that perform memory and switching functions in a single device based on a positive feedback loop.

It is another object of the present disclosure to implement a logically operatable binarized neural network with excellent uniformity and stability due to almost no characteristic deviation by using a quasi-nonvolatile memory device applicable to a CMOS process as a synaptic device.

It is still another object of the present disclosure to implement a binarized neural network circuitry that allows a memory array composed of the quasi-nonvolatile memory device based on the positive feedback loop to perform the activation function of a neuron circuit on its own and has excellent uniformity and stability.

It is yet another object of the present disclosure to implement a binarized neural network circuitry that can be utilized in next-generation artificial intelligence computing technology by reducing standby power through the utilization of the excellent memory characteristics of the quasi-nonvolatile memory device and increasing computational efficiency with low power consumption through excellent switching characteristics.

In accordance with an aspect of the present disclosure, the above and other objects can be accomplished by the provision of a binarized neural network circuitry, wherein a diode structure is positioned in a channel region between a drain terminal and a source terminal, a gate terminal is positioned on the diode structure, an operation state is determined by occurrence of a latch-up or latch-down phenomenon due to a positive feedback loop in the channel region based on different voltages applied to the drain terminal and the gate terminal, respectively, and a plurality of quasi-nonvolatile memory devices that implement memory characteristics of remembering a memory state are included as holes or electrons in a potential well in the channel region due to the positive feedback loop are accumulated, and the plural quasi-nonvolatile memory devices are a pair of two quasi-nonvolatile memory devices that operate as a single synaptic cell and are connected in parallel to form an array circuit, memory states of the two quasi-nonvolatile memory devices are determined and stored based on an input line applied from an input line processor connected to the array circuit and a weight update signal applied from a synaptic line processor connected to the array circuit, and a MAC (multiply-accumulate) operation result is output using a combination of the memory states.

The synaptic cell may remember a synaptic weight through the combination of the operation states of the two quasi-nonvolatile memory devices, and when the input line is applied, it may perform an XNOR logic operation according to the input line and the synaptic weight and output an XNOR logic operation result.

Each of the two quasi-nonvolatile memory devices may be determined to be in one of a first operation state and a second operation state based on the input line, and may be determined to be in the first operation state when the input line is higher than a reference voltage $V_{High}$ and to be in the second operation state when the input line is lower than the reference voltage $V_{Low}$.

When the input line is a negative value, an upper quasi-nonvolatile memory device among the two quasi-nonvolatile memory devices may be applied with the voltage lower than the reference, and a lower quasi-nonvolatile memory device thereamong may be applied with the voltage higher than the reference, and when the input line is a positive value, the upper quasi-nonvolatile memory device may be applied with the voltage higher than the reference, and the lower quasi-nonvolatile memory device may be applied with the voltage lower than the reference.

Each of the two quasi-nonvolatile memory devices may be determined to be in one of a first operation state and a second operation state based on the input line, and may be determined to be in the first operation state when the input line is higher than the reference voltage $V_{High}$ and to be in the second operation state when the input line is lower than the reference voltage $V_{Low}$, and a synaptic weight may be determined as one of a negative value and a positive value based on a combination of the first operation state and the second operation state.

The synaptic cell may determine a synaptic weight as the positive value when the first quasi-nonvolatile memory device among the two quasi-nonvolatile memory devices is in the second operation state and the second quasi-nonvolatile memory device thereamong is in the first operation state, determine a synaptic weight as the negative value when the first quasi-nonvolatile memory device is in the first operation state and the second quasi-nonvolatile memory device is in the second operation state, determine a synaptic weight as the negative value when the first quasi-nonvolatile memory device is in the second operation state and the second quasi-nonvolatile memory device is in the first operation state, and determine a synaptic weight as the positive value when the first quasi-nonvolatile memory device is in the first operation state and the second quasi-nonvolatile memory device is in the second operation state.

A plurality of synaptic cells may be configured based on the plural quasi-nonvolatile memory devices, the plural synaptic cells may be connected in parallel to provide a synaptic weight matrix composed of synaptic weights stored in each thereof, and a vector-matrix multiplication operation between the provided synaptic weight matrix and a matrix of input vectors based on an input line to determine the synaptic weights may be performed to output an XNOR binary operation result.

When the synaptic cells are composed of 2 rows and 2 columns, a logic state may be output as "0" if a current detected in relation to the output XNOR binary operation result is adjacent to a reference current, the logic state may be output as "+2" if the detected current is twice the reference current, and the logic state may be output as "-2" if the reference current is adjacent to "0".

The quasi-nonvolatile memory device may receive a drain voltage of the drain terminal as the input line, generate a latch-up phenomenon due to the positive feedback loop as the applied input line increases in a positive direction, and have one of two memory states for the channel region, the input line where the latch-up phenomenon occurs may be controlled as a gate voltage of the gate terminal is applied as the weight update signal, and a synaptic state related to one of the memory states may be updated according to the input line and the application of the weight update signal, and the MAC operation function may be performed according to the synaptic weight.

The memory array may connect the drain terminal, the gate terminal and the source terminal in parallel in the plural quasi-nonvolatile memory devices to form an input line, a weight line and an output line, respectively, the input line may be arranged perpendicular to the weight line and the output line, and the weight line and the output line may be arranged in parallel.

The input line may receive the input line from an input line processor, the weight line may receive the weight update signal from a weight line processor, and the output line may be connected to a current sensing processor, and output the MAC operation result based on the input line and the weight update signal to a next artificial neural network stage through the current sensing processor.

The quasi-nonvolatile memory device may include one of a quasi-nonvolatile memory device using a single gate, a quasi-nonvolatile memory device using a double gate, and a quasi-nonvolatile memory device using a triple gate.

## BRIEF DESCRIPTION OF THE DRAWINGS

The above and other objects, features and other advantages of the present disclosure will be more clearly understood from the following detailed description taken in conjunction with the accompanying drawings, in which:

FIGS. 1A to 1D illustrate the structure and circuit symbols of a quasi-nonvolatile memory device constituting a binarized neural network circuitry according to an embodiment of the present disclosure;
FIGS. 2A to 2D illustrate the operational characteristics of a quasi-nonvolatile memory device constituting the binarized neural network circuitry according to an embodiment of the present disclosure;
FIG. 3 illustrates a binarized neural network circuitry according to an embodiment of the present disclosure using a quasi-nonvolatile memory device;
FIGS. 4A and 4B illustrate the logical operation of a binarized neural network using the quasi-nonvolatile memory device according to an embodiment of the present disclosure;
FIGS. 5A to 5C illustrate the matrix MAC (multiply-accumulate) operation for a binarized neural network using the quasi-nonvolatile memory device according to an embodiment of the present disclosure;
FIG. 6 illustrates the memory operation of the quasi-nonvolatile memory device according to an embodiment of the present disclosure;
FIG. 7 illustrates the simulation structure of the binarized neural network circuitry according to an embodiment of the present disclosure using a quasi-nonvolatile memory device; and
FIGS. 8A to 8C illustrate simulation results of the binarized neural network circuitry according to an embodiment of the present disclosure using a quasi-nonvolatile memory device.

## DETAILED DESCRIPTION OF THE DISCLOSURE

The embodiments will be described in detail herein with reference to the drawings.

However, it should be understood that the present disclosure is not limited to the embodiments according to the concept of the present disclosure, but includes changes, equivalents, or alternatives falling within the spirit and scope of the present disclosure.

In the following description of the present disclosure, a detailed description of known functions and configurations incorporated herein will be omitted when it may make the subject matter of the present disclosure unclear.

The terms used in the specification are defined in consideration of functions used in the present disclosure, and can be changed according to the intent or conventionally used methods of clients, operators, and users. Accordingly, definitions of the terms should be understood on the basis of the entire description of the present specification.

In description of the drawings, like reference numerals may be used for similar elements. The singular expressions in the present specification may encompass plural expressions unless clearly specified otherwise in context.

In this specification, expressions such as "A or B" and "at least one of A and/or B" may include all possible combinations of the items listed together.

Expressions such as "first" and "second" may be used to qualify the elements irrespective of order or importance, and are used to distinguish one element from another and do not limit the elements.

It will be understood that when an element (e.g., first) is referred to as being "connected to" or "coupled to" another element (e.g., second), it may be directly connected or coupled to the other element or an intervening element (e.g., third) may be present.

As used herein, "configured to" may be used interchangeably with, for example, "suitable for", "ability to", "changed to", "made to", "capable of", or "designed to" in terms of hardware or software.

In some situations, the expression "device configured to" may mean that the device "may do ~" with other devices or components.

For example, in the sentence "processor configured to perform A, B, and C", the processor may refer to a general purpose processor (e.g., CPU or application processor) capable of performing corresponding operation by running a dedicated processor (e.g., embedded processor) for performing the corresponding operation, or one or more software programs stored in a memory device.

In addition, the expression "or" means "inclusive or" rather than "exclusive or".

That is, unless otherwise mentioned or clearly inferred from context, the expression "x uses a or b" means any one of natural inclusive permutations.

Terms, such as "unit" or "module", etc., should be understood as a unit that processes at least one function or operation and that may be embodied in a hardware manner, a software manner, or a combination of the hardware manner and the software manner.

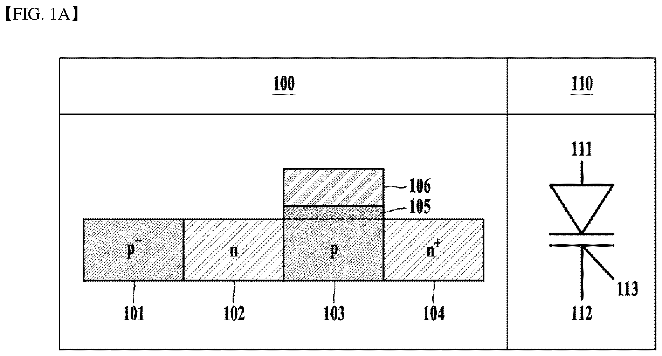

FIGS. 1A to 1D illustrate the structure and circuit symbols of a quasi-nonvolatile memory device constituting a binarized neural network circuitry according to an embodiment of the present disclosure.

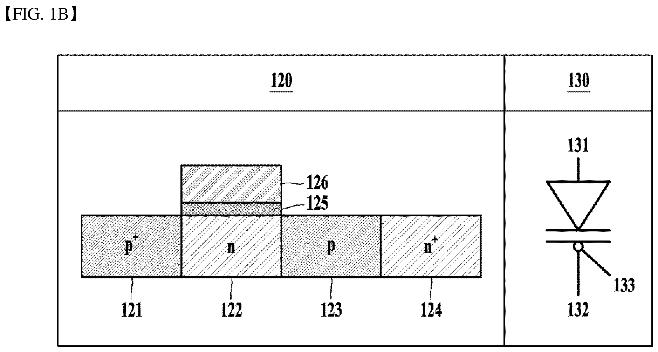

FIGS. 1A and 1B exemplify the structure and circuit symbols of a quasi-nonvolatile memory device using a single gate, which constitutes the binarized neural network circuitry according to an embodiment of the present disclosure.

Referring to FIG. 1A, a quasi-nonvolatile memory device 100 constituting the binarized neural network circuitry according to an embodiment of the present disclosure includes a drain terminal 101, a source terminal 104 and a channel region formed between the drain terminal 101 and the source terminal 104. The channel region includes a first channel region 102 and a second channel region 103.

A gate insulating film 105 is positioned on the second channel region 103, and a gate terminal 106 is positioned on the gate insulating film 105.

In a circuit symbol 110 of the quasi-nonvolatile memory device 100 constituting the binarized neural network circuitry according to an embodiment of the present disclosure, a channel region is positioned between a drain terminal 111 and a source terminal 112 and connected to a gate terminal 113.

Referring to FIG. 1B, a quasi-nonvolatile memory device 120 constituting the binarized neural network circuitry according to an embodiment of the present disclosure includes a drain terminal 121, a source terminal 124 and a channel region formed between the drain terminal 121 and the source terminal 124. The channel region includes a first channel region 122 and a second channel region 123.

A gate insulating film 125 is positioned on the first channel region 122, and a gate terminal 126 is positioned on the gate insulating film 125.

In a circuit symbol 130 of the quasi-nonvolatile memory device 120 constituting the binarized neural network circuitry according to an embodiment of the present disclosure, a channel region is positioned between a drain terminal 131 and a source terminal 132 and connected to a gate terminal 133.

According to an embodiment of the present disclosure, an input line is connected to the drain terminal 111 or the drain terminal 131, an output line is connected to the source terminal 112 or the source terminal 132, and a memory state in the channel region is determined according to the update of synaptic weight.

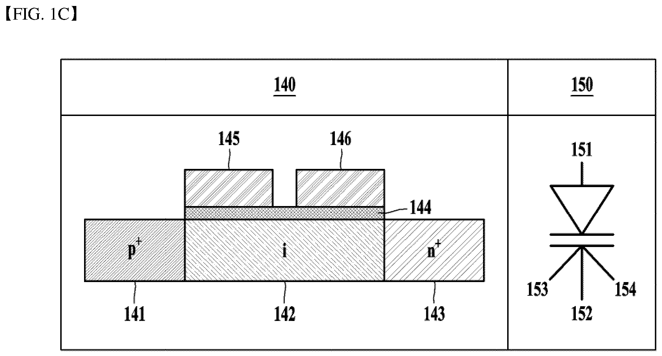

FIG. 1C exemplifies the structure and circuit symbols of a quasi-nonvolatile memory device using a double gate, which constitutes the binarized neural network circuitry according to an embodiment of the present disclosure.

Referring to FIG. 1C, a quasi-nonvolatile memory device 140 constituting the binarized neural network circuitry according to an embodiment of the present disclosure includes a drain terminal 141, a source terminal 143, and an intrinsic region 142 positioned between the drain terminal 141 and the source terminal 143. A gate insulating film 144 is positioned on the intrinsic region 142, and a first gate terminal 145 and a second gate terminal 146 are positioned on the gate insulating film 144.

The intrinsic region 142 operates as a channel region based on a gate volage that is input from one of the first gate terminal 145 and the second gate terminal 146.

In a circuit symbol 150 of the quasi-nonvolatile memory device 140 constituting the binarized neural network circuitry according to an embodiment of the present disclosure, an intrinsic region is positioned between a drain terminal 151 and a source terminal 152 and connected to a first gate terminal 153 and a second gate terminal 154.

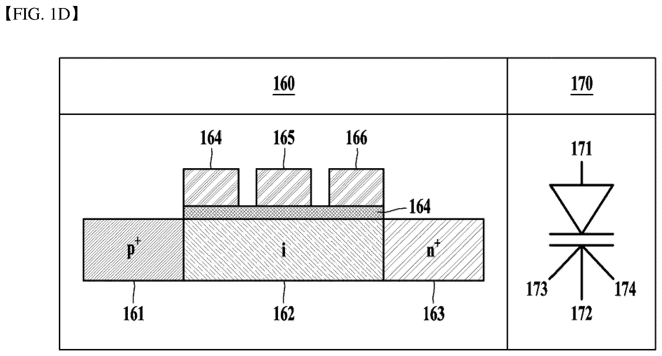

FIG. 1D exemplifies the structure and circuit symbols of a quasi-nonvolatile memory device using a triple gate, which constitutes the binarized neural network circuitry according to an embodiment of the present disclosure.

Referring to FIG. 1D, a quasi-nonvolatile memory device 160 constituting the binarized neural network circuitry according to an embodiment of the present disclosure includes a drain terminal 161, a source terminal 163 and an intrinsic region 162 positioned between the drain terminal 161 and the source terminal 163. A gate insulating film 164 is positioned on the intrinsic region 162, and a programming gate terminal 165 and a control gate terminal 166 are positioned on the gate insulating film 164.

The intrinsic region 162 acts as a channel region based on a gate voltage that is input from the programming gate terminal 165.

More specifically, when the level of program voltage $V_{PG}$ that is input from the intrinsic region 162 to the programming gate terminal 165 is high, the intrinsic region 162 may operate as an n channel corresponding to a first channel operation, and when the level of the program voltage $V_{PG}$ is low, it may operate as a p channel corresponding to a second channel operation.

When the quasi-nonvolatile memory device 160 performs the first channel operation, it may be determined to be in an on state when the level of control voltage $V_{CG}$ that is input through the control gate terminal 166 is high, and it may be determined to be in an off state when the level of the control voltage $V_{CG}$ applied through the control gate terminal 166 is low.

In a circuit symbol 170 of the quasi-nonvolatile memory device 160 constituting the binarized neural network circuitry according to an embodiment of the present disclosure, an intrinsic region is positioned between a drain terminal 171 and a source terminal 172 and connected to a programming gate terminal 173 and a control gate terminal 174.

For example, terminals such as a drain terminal, a gate terminal and a source terminal may be referred to as electrodes such as a drain electrode, a source electrode and a gate electrode.

That is, the quasi-nonvolatile memory device 106 constituting the binarized neural network circuitry according to an embodiment of the present disclosure may have a structure wherein a single gated electrode terminal is doped on a doped n- or p-type channel region on a silicon channel, or multiple gated electrode terminals are deposited on an intrinsically doped region.

In addition, the quasi-nonvolatile memory device 106 operates by inducing a positive feedback loop through a potential barrier, and has switching and memory characteristics, so it may be configured as a synaptic device in a binarized neural network.

Therefore, the present disclosure demonstrates that a self-activating binarized neural network circuitry can be implemented using the quasi-nonvolatile memory device that performs memory and switching functions in a single device based on the positive feedback loop.

For example, the quasi-nonvolatile memory device may include one of a quasi-nonvolatile memory device using a single gate, a quasi-nonvolatile memory device using a double gate, and a quasi-nonvolatile memory device using a triple gate.

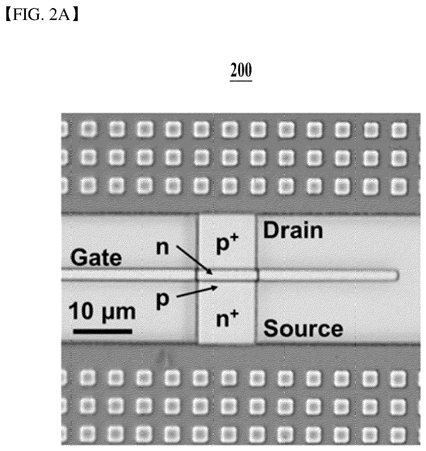

FIGS. 2A to 2D illustrate the operational characteristics of a quasi-nonvolatile memory device constituting the binarized neural network circuitry according to an embodiment of the present disclosure.

FIG. 2A exemplifies the optical image of the quasi-nonvolatile memory device according to an embodiment of the present disclosure.

Referring to FIG. 2A, an image 200 shows a magnified portion of the quasi-nonvolatile memory device. The image 200 may be the optical image of a quasi-nonvolatile memory device for performing matrix MAC operations between binarized weights and analog inputs of the binarized neural network circuitry.

The image 200 may be the optical image of a quasi-nonvolatile memory device consisting of a heavily p-doped ($p^+$) drain, a heavily n-doped ($n^+$) source, an n and p-doped region on a Silicon-On-Insulator (SOI) wafer.

$SiO_2$ gate oxide and a $p^+$ poly-Si gate (width: 1.0-$\mu$m) layer are positioned on an n-doped region.

A poly-Si gate can control a potential barrier in an n-doped region by controlling hole injection in a $p^+$ drain region.

Accumulation of holes injected into a p-doped region induces electron injection into an $n^+$ source region because it lowers the potential barrier height in a p-doped region.

This iterative interplay (i.e., the PF loop mechanism) between carrier injection and the modulation of the potential barrier height is essential for using a pair of quasi-nonvolatile memory devices as synaptic cells in a binarized neural network circuitry.

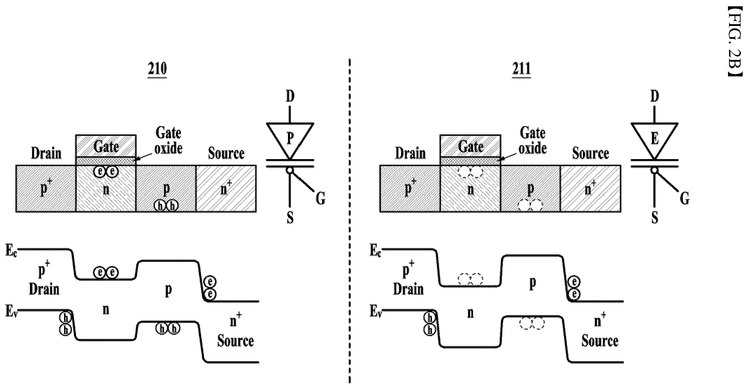

FIG. 2B exemplifies the operation of the quasi-nonvolatile memory device according to an embodiment of the present disclosure.

FIG. 2B shows a first operation state 210 and second operation state 211 of the quasi-nonvolatile memory device according to an embodiment of the present disclosure.

The first operation state 210 represents a programmed state, and the second operation state 211 represents an erased state.

In the first operation state 210, excess charge carriers injected from the n+ source and p$^+$ drain regions accumulate in the potential wells of the n- and p-doped regions, lowering the height of the potential barrier.

Conversely, in the second operation state 211, the potential barrier is raised, so that excess charge carriers are depleted from a potential well.

Therefore, the first and second operation states are determined by the presence or absence of excess charge carriers in the potential well.

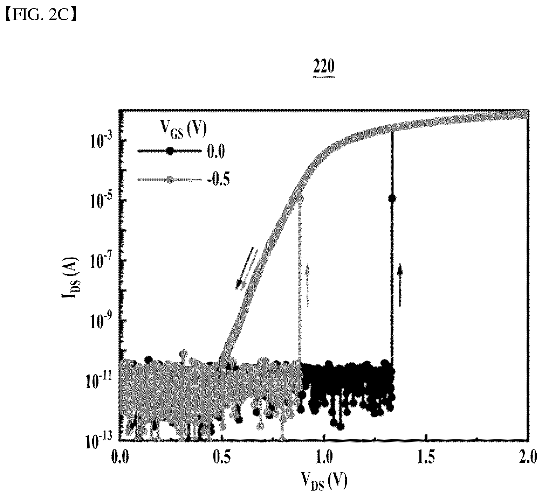

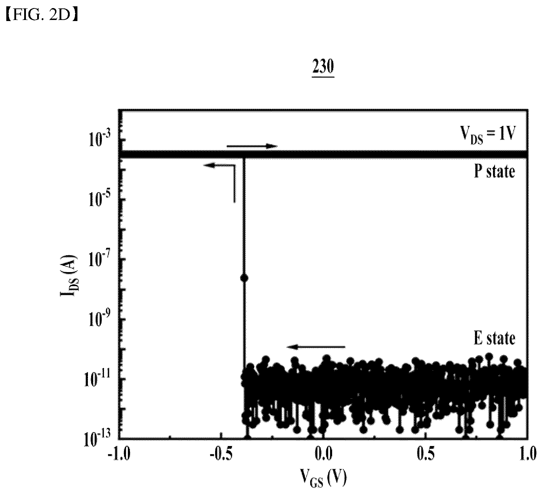

FIGS. 2C and 2D exemplify the operation state of the quasi-nonvolatile memory device according to an embodiment of the present disclosure.

Referring to FIGS. 2C and 2D, Graphs 220 and 230 show the switching characteristics of the quasi-nonvolatile memory device.

Referring to Graph 220, when drain voltage $V_{DS}$ is swept (forward swept) from 0.0 V to 2.0 V, $I_{DS}$ suddenly increases at $V_{DS}$ = 1.3 V and 0.8 V for $V_{GS}$ = 0.0 V and -0.5 V, respectively, due to the generation of a positive feedback loop.

Next, referring to Graph 230, the $I_{DS}$ for the reverse sweep of the drain voltage from 2.0 V to 0.0 V may be gradually reduced as the carrier injection in the drain and source regions decreases.

Similarly, the quasi-nonvolatile memory device exhibits steep switching characteristics in the gate voltage $V_{GS}$ and the $I_{DS}$ characteristics.

In addition, due to the excess charge carriers accumulated in the potential well, the quasi-nonvolatile memory device exhibits bistable characteristics with a high on/off current ratio ($I_{ON}/I_{OFF}$) of $3.5\times10^7$, and these excellent electrical characteristics may be used to operate a binarized neural network circuitry.

The quasi-nonvolatile memory device exhibits a latch-up phenomenon occurring due to a positive feedback loop as the drain voltage increases in the positive direction, has two states.

Here, the quasi-nonvolatile memory device may have a drain voltage that varies without a latch depending on a gate voltage.

The binarized neural network according to an embodiment of the present disclosure may perform synaptic weight update and MAC operation functions by applying a drain voltage and a gate voltage based on the characteristics of this single device.

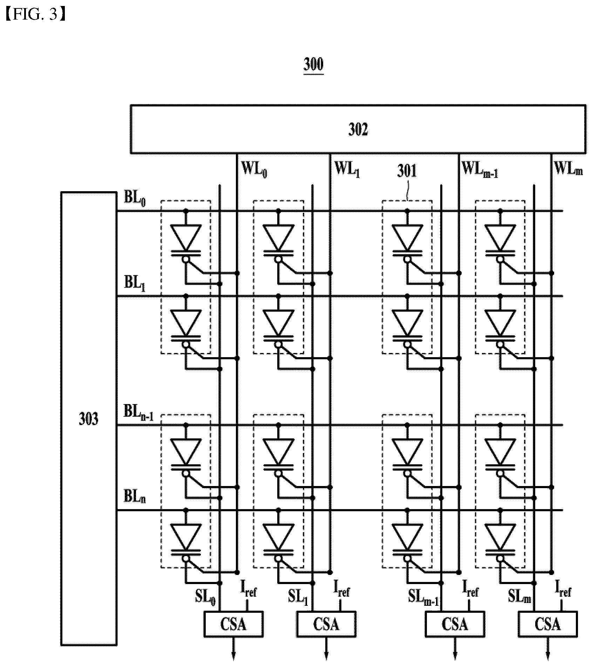

FIG. 3 illustrates a binarized neural network circuitry according to an embodiment of the present disclosure using a quasi-nonvolatile memory device.

FIG. 3 exemplifies the binarized neural network circuitry according to an embodiment of the present disclosure using a quasi-nonvolatile memory device.

Referring to FIG. 3, the binarized neural network circuitry 300 according to an embodiment of the present disclosure using a quasi-nonvolatile memory device may include a plurality of quasi-nonvolatile memory devices wherein a diode structure is positioned in a channel region between a drain terminal and a source terminal, a gate terminal is positioned on the diode structure so that unidirectional switching is implemented through potential barrier control in the channel region based on different voltages respectively applied to the drain terminal and the gate terminal, and memory characteristics are implemented as holes or electrons are accumulated in a potential well due to a positive feedback loop.

For example, the binarized neural network circuitry 300 using a quasi-nonvolatile memory device may be an artificial neural network that reduces computation time and power consumption by binarizing synaptic weights.

Therefore, the present disclosure may implement a self-activating binarized neural network circuitry that can increase the area and computational efficiency of an artificial neural network by having the excellent memory characteristics of a quasi-nonvolatile memory device that has unidirectional switching characteristics through potential wall control and also has memory characteristics as holes or electrons accumulate in the potential well due to a positive feedback loop, and by having its own activation function through the linearity of output signals according to input signals.

The plural quasi-nonvolatile memory devices may operate as a synaptic device 301 in a memory array connected in parallel, and output a MAC (multiply-accumulate) operation result based on an input signal applied from an input line processor 302 connected to the memory array and a weight update signal applied from a synaptic line processor 303 connected to the memory array.

For example, the input line processor 302 may be a bit line switch matrix input processor, and the synaptic line processor 303 may be a word line decoder.

As the binarized neural network circuitry 300, a memory array connects a drain terminal, a gate terminal and a source terminal in parallel in the plural quasi-nonvolatile memory devices to form an input line BL, a weight line WL and an output line SL, respectively. The input line BL may be arranged perpendicular to the weight line WL and the output line SL, and the weight line WL and the output line SL may be arranged in parallel.

The drain terminal is connected to an input line IL, the gate terminal is connected to the weight line WL, and the source terminal is connected to an output line SL.

The output line SL is connected to a current sensing processor (current sense amplifier, CSA), so that the MAC operation result based on the input line IL and the weight update signal WL may be output to the next artificial neural network stage through a current sensing processor.

For example, the current sensing processor can be referred to as a current sense amplifier (CSA).

The gate terminal and the source terminal may form the weight line WL and the output line SL, respectively.

For example, in the memory array, a first weight line $WL_0$ to an Mth weight line $WL_m$ and a first output line $SL_0$ to an Mth output line $SL_m$ may be constituted depending on the number (M) of rows formed by the plural quasi-nonvolatile memory devices.

The number of the input lines BL corresponding to columns and the number of the output lines SL corresponding to rows may be equal or different.

However, the number (M) of the weight lines WL and the number (M) of the output lines BL should be the same.

For example, N and M may be the same or different as the number of elements composing the rows and columns can be composed of the number of inputs and outputs.

For example, a first input line $BL_0$ to an Nth input line $BL_n$ may be configured depending upon N that is the number of rows formed by the plural quasi-nonvolatile memory devices in the memory array.

The quasi-nonvolatile memory device receives the drain voltage of the drain terminal as an input line, and generates a latch-up phenomenon due to a positive feedback loop as the applied input line increases in a positive direction.

The quasi-nonvolatile memory device has one of two memory states for the channel region, and an input line on which a latch-up phenomenon occurs may be controlled by applying the gate voltage of the gate terminal as a weight update signal.

In addition, a synaptic cell 301, which consists of two quasi-nonvolatile memory devices, may update a synaptic state related to one memory state according to an input line and the application of a weight update signal, and may perform a MAC operation function according to a synaptic weight.

According to an embodiment of the present disclosure, the binarized neural network circuitry 300 may include a plurality of quasi-nonvolatile memory devices wherein a diode structure is positioned in a channel region between a drain terminal and a source terminal, a gate terminal is positioned on the diode structure, an operation state is determined by a latch-up or latch-down phenomenon occurring in the channel region due to a positive feedback loop based on different voltages applied to each of the drain terminal and the gate terminal, and the memory characteristic of remembering a memory state is implemented as holes or electrons are accumulated in a potential well in the channel region due to the positive feedback loop.

For example, the plural quasi-nonvolatile memory devices are a pair of two quasi-nonvolatile memory devices that operate as one synaptic cell 301, are connected in parallel to form an array circuit, determine and store the memory states of the two quasi-nonvolatile memory devices based on an input line applied from the input line processor connected to the array circuit and a weight update signal applied from a synaptic line processor connected to the array circuit, and output a MAC (multiply-accumulate) operation result using a combination of the memory states.

According to an embodiment of the present disclosure, the synaptic cell 301 may memorize a synaptic weight through a combination of the operation states of two quasi-nonvolatile memory devices, and when an input line is applied, perform an XNOR logic operation according to the input line and the synaptic weight, and output an XNOR logic operation result.

For example, the synaptic cell 301 may be configured such that if an input line has a negative value, the upper quasi-nonvolatile memory device among the two quasi-nonvolatile memory devices may be supplied with a voltage below a reference level, and the lower quasi-nonvolatile memory device may be supplied with a voltage above the reference level, and if the input line has a positive value, the upper quasi-nonvolatile memory device among the two quasi-nonvolatile memory devices may be supplied with a voltage above the reference level, and the lower quasi-nonvolatile memory device may be supplied with a voltage below the reference level.

The binarized neural network circuitry 300 according to an embodiment of the present disclosure includes a plurality of synaptic cells 301 based on the plural quasi-nonvolatile memory devices, provides a synaptic weight matrix composed of synaptic weights stored in each of the plural synaptic cells connected in parallel, and performs a vector-matrix multiplication operation between the provided synaptic weight matrix and the matrix of an input vector based on an input line for determining a synaptic weight, thereby outputting an XNOR binary operation result.

Therefore, the present disclosure demonstrates that a binarized neural network can perform both memory functions and logical operation functions on a memory array consisting of quasi-nonvolatile memory devices that perform memory and switching functions in a single device based on a positive feedback loop.

In addition, the present disclosure shows that a quasi-nonvolatile memory device applicable to a CMOS process can be used as a synaptic device, thereby implementing a logically operatable binarized neural network with excellent uniformity and stability due to almost no characteristic deviation.

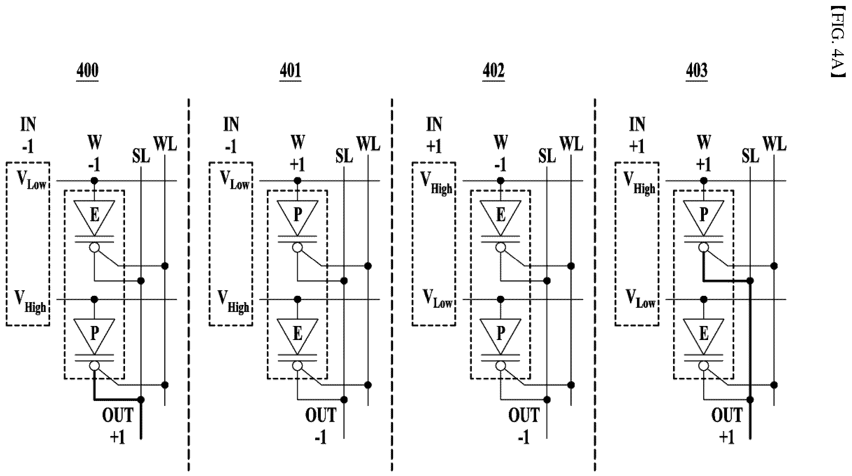

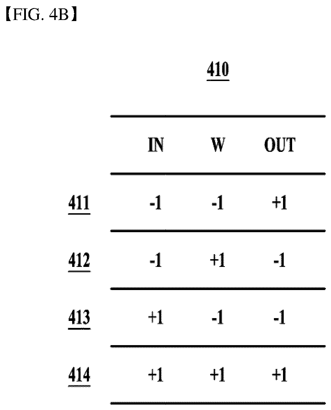

FIGS. 4A and 4B illustrate the logical operation of a binarized neural network using the quasi-nonvolatile memory device according to an embodiment of the present disclosure.

FIG. 4A illustrates a circuit related to the logical operation of the binarized neural network using the quasi-nonvolatile memory device according to an embodiment of the present disclosure, and FIG. 4B illustrates a table of inputs and outputs of the logical operation of the binarized neural network using the quasi-nonvolatile memory device according to an embodiment of the present disclosure.

FIG. 4A shows circuits corresponding to a first example 400, a second example 401, a third example 402 and a fourth example 403, and the inputs and outputs of the circuits.

According to the first example 400, the synaptic cell determines the synaptic weight as a positive value when the first quasi-nonvolatile memory device among the two quasi-nonvolatile memory devices is in a second operation state and the second quasi-nonvolatile memory device thereamong is in a first operation state.

According to the second example 401, the synaptic cell determines the synaptic weight as a negative value when the first quasi-nonvolatile memory device is in a first operation state and the second quasi-nonvolatile memory device is in a second operation state.

According to the third example 402, the synaptic cell determines the synaptic weight as a negative value when the first quasi-nonvolatile memory device is in a second operation state and the second quasi-nonvolatile memory device is in a first operation state.

According to the fourth example 403, the synaptic cell may determine the synaptic weight as a positive value when the first quasi-nonvolatile memory device is in a first operation state and the second quasi-nonvolatile memory device is in a second operation state.

For example, the first operation state may be a program state, and the second operation state may be an erased state.

More specifically, when $V_{Low}$ and $V_{High}$ are applied to the upper element BL and the lower element BL, respectively, the input signal IN means "-1" corresponding to negative. Conversely, when the BL voltage combination is $V_{High}$ and $V_{Low}$, respectively, the input signal A represents "+1" corresponding to positive.

Here, the $V_{High}$ may represent the voltage that reads the memory state of the device, and $V_{Low}$ may represent the voltage that cannot read the memory state of the device.

Both the first example 400 and the second example 401 represent the case where the weight W is "-1", i.e., when the memory state combination of the upper and lower elements is the second operation state and the first operation state.

First, in the case of the first example 400, the memory state of the lower element in the program state can be read when $V_{Low}$ and $V_{High}$ are applied to the BLs of the upper element in the erased state and the lower element in the program state, respectively, so that the output current $I_{OUT}$ can flow at a high level,.

This may mean that in the MAC operation of the XNOR-operation binarized neural network, the result of the multiplication operation of the input IN of "-1" and the synaptic weight W of "-1" is "+1".

In the case of the third example 402, when $V_{High}$ and $V_{Low}$ are applied to the upper and lower input lines BL, respectively, the memory state of the upper element, which is in an erased state, is read, and the output current $I_{OUT}$ flows at a very low level.

This may mean that in the MAC operation of the XNOR-operation binarized neural network, the result of the multiply operation of the input IN of "+1" and the synaptic weight W of "-1" is "-1".

Both the second example 401 and the fourth example 403 may represent the case where W is "+1", i.e., when the memory state combination of the upper and lower elements is the first operation state and the second operation state.

In the case of the second example 401, the memory state of the lower element, which is in an erased state, is read when $V_{Low}$ and $V_{High}$ are applied to the inputs BL of the upper element of the first operation state and the lower element of the second operation state, respectively, so that the output current $I_{OUT}$ flows at a very low level.

This means that in the MAC operation of the XNOR-operation binarized neural network, the result of the multiplication operation of the input IN of "-1" and the synaptic weight W of "+1" is "-1".

In the case of the fourth example 403, the memory state of the upper element, which is the first operation state, is read when $V_{High}$ and $V_{Low}$ are applied to the upper and lower input lines BLs, respectively, so that the output current $I_{OUT}$ flows to a high level

This can represent that in the MAC operation of the XNOR-operation binarized neural network, the result of the multiplication operation of the input IN of "+1" and the synaptic weight W of "+1" is "+1".

That is, so as to determine each of the two quasi-nonvolatile memory devices to be in one operation state of the first operation state and the second operation state based on the input line, the synaptic cell may be determined to be in the first operation state when the input line is voltage $V_{High}$ higher than the reference, and it may be determined to be in the second operation state when the input line is voltage $V_{Low}$ lower than the reference.

Referring to FIG. 4B, a truth table 410 summarizes and exemplifies the input IN, weight W related to the first example 400 to the fourth example 403 described above, and the consequent output OUT.

In the truth table 410, a first example 411, a second example 412, a third example 413 and a fourth example 414 are summarized.

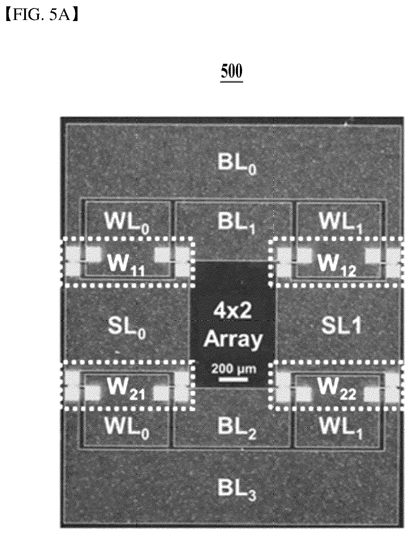

FIGS. 5A to 5C illustrate the matrix MAC (multiply-accumulate) operation for a binarized neural network using the quasi-nonvolatile memory device according to an embodiment of the present disclosure.

FIGS. 5A to 5C exemplify a 2×2 cell array performing matrix MAC (multiply-accumulate) operation for the binarized neural network using the quasi-nonvolatile memory device according to an embodiment of the present disclosure, wherein the 2×2 cell array performs matrix MAC operations according to the vector matrix multiply (VMM) of a 2×1 IN vector.

Referring to FIG. 5A, an image 500 illustrates the optical image of a 2×2 cell array in relation to the matrix MAC operation of a binary computation network.

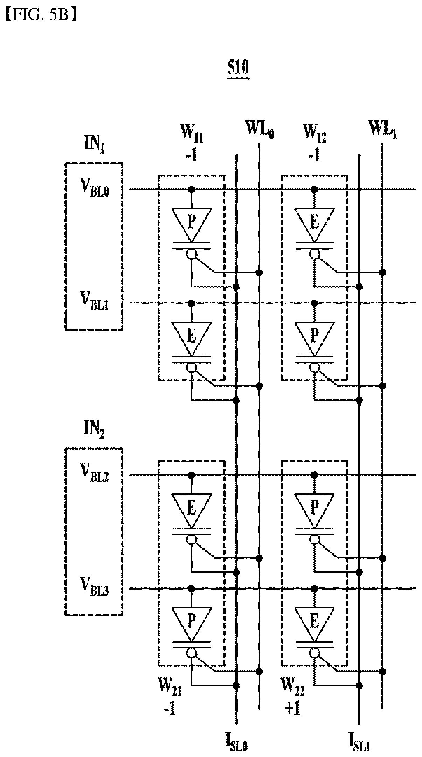

Referring to FIG. 5B, a circuit diagram 510 illustrates the circuit diagram of the 2×2 cell array in relation to the matrix MAC operation of the binary computation network.

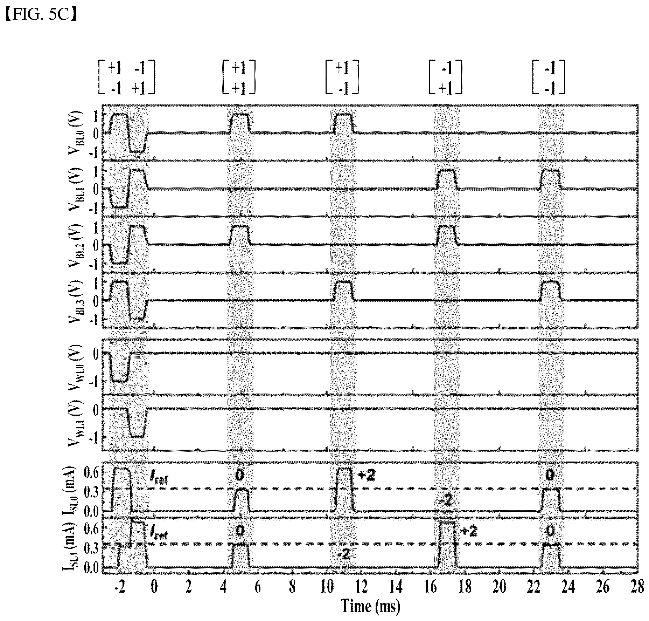

Referring to FIG. 5C, a timing diagram 520 illustrates a timing diagram for the input and output of the 2×2 cell array in relation to the matrix MAC operation of the binary computation network.

As in the circuit diagram 510 and the timing diagram 520, $\begin{bmatrix} +1 & -1 \\ -1 & +1 \end{bmatrix}$ is selected as a W matrix, and all cell array operations utilize the operational principles explained with reference to FIGS. 4A and 4B.

Meanwhile, an input matrix is $\begin{bmatrix} IN_1 \\ IN_2 \end{bmatrix}$, and "+1" and "-1" may be applied as inputs.

The matrix MAC operation may be defined according to Mathematical Formula 1 below.

[Mathematical Formula 1]

$$\begin{bmatrix} W_{11} & W_{12} \\ W_{21} & W_{22} \end{bmatrix} \begin{bmatrix} IN_1 \\ IN_2 \end{bmatrix} = \begin{bmatrix} OUT_1 \\ OUT_2 \end{bmatrix}$$

In Mathematical Formula 1, W may represent a binarized weight (conductance), IN may represent an input signal (voltage), and OUT may represent an output signal (current) according to the matrix operation.

The binarized neural network cell array shows that the word line voltage $V_{WL}$ is applied only to weight updates, after which the cell array performs matrix MAC operations using various IN vectors.

The binarized neural network cell array maintains a synaptic weight without consuming energy.

A plurality of synaptic cells are configured based on the plural quasi-nonvolatile memory devices, and the plural synaptic cells are connected in parallel to each other to provide a synaptic weight matrix composed of synaptic weights stored in each thereof, and a vector-matrix multiplication operation between the provided synaptic weight matrix and the matrix of an input vector based on an input line for determining the synaptic weight is performed to output an XNOR binary operation result.

In the case where synaptic cells are composed of 2 rows and 2 columns, the logic state may be output as "0" when the current $I_{SL}$ detected in relation to the output XNOR binary operation result is adjacent to the reference current $I_{REF}$, the logic state may be output as "+2" when the current $I_{SL}$ is twice the reference current $I_{REF}$, and the logic state may be output as "-2" when the reference current $I_{REF}$ is adjacent to "0".

The reference current $I_{REF}$ may be half (0.33 mA) of the maximally detected current $I_{SL}$, and the logical value may be equal to logic 0.

When performing an operation, a final operation result is divided into "+2", "0", and "-2" depending on the combination of the synaptic weight matrix and the input vector.

It is confirmed that the operation result of "+2" has a value exactly twice that of "0", and "-2" has a very low level of detection current of 0 mA.

The matrix MAC operation of XNOR-operation binarized neural network is implemented through the quasi-nonvolatile memory device connected in parallel by combining the synaptic weight matrix and the input vector.

The quasi-nonvolatile memory device, a component of the synaptic cell, exhibits uninterrupted VBL properties during weight updates and matrix MAC operations.

The quasi-nonvolatile memory device is immune to the sneak path problem because of its inherent commutation characteristics due to its well-defined $p^+$-n-p-$n^+$ structure.

As a result, a synaptic cell architecture based on two transistors (T) can be realized due to the excellent properties of the quasi-nonvolatile memory device with a $p^+$-n-p-$n^+$ structure, which can form a compact synaptic array in a binarized neural network circuitry.

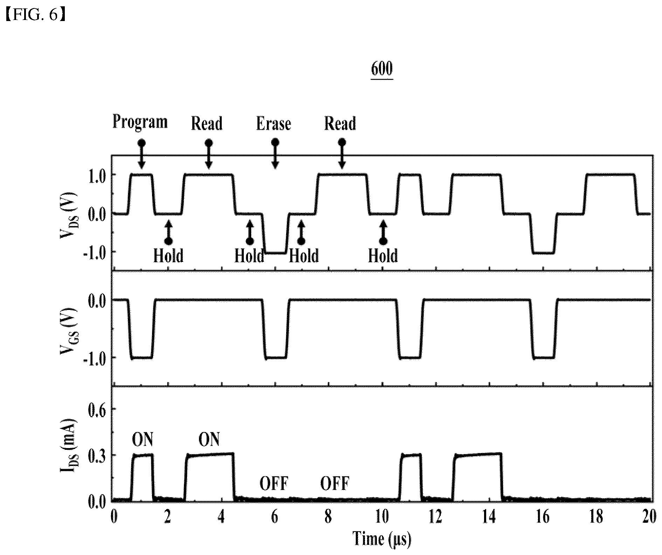

FIG. 6 illustrates the memory operation of the quasi-nonvolatile memory device according to an embodiment of the present disclosure.

FIG. 6 illustrates a memory function in relation to the memory operation of the quasi-nonvolatile memory device according to an embodiment of the present disclosure.

Referring to FIG. 6, Graph 600 shows the sequence of program, erase, hold, and read operations of the quasi-nonvolatile memory device.

During the program operation, voltage $V_{DS}$ is -1 V, which injects charge carriers into n- and p-doped regions, while voltage $V_{GS}$ is -1 V, which lowers the potential barrier height in the n-doped region.

As a result, the device enters a programmed state, creating a positive feedback loop and accumulating charge carriers in the potential well.

During the hold operation, the quasi-nonvolatile memory device retains excess charge carriers in a potential well without external bias due to its well-defined $p^+$-n-p-$n^+$ structure.

Therefore, it can be confirmed that the current $I_{DS}$ reaches a high level of 0.3 mA in the read operation where voltage $V_{DS}$ = 1 V and voltage $V_{GS}$ = 0 V.

On the other hand, in the erase operation where voltage $V_{DS}$ = 1 V and voltage $V_{GS}$ = -1 V, the positive feedback loop is removed and the accumulated charge carriers recombine.

In the erased state, a low level of current $I_{DS}$ is measured during the read operation.

As a result, Graph 600 shows that a quasi-nonvolatile memory device exhibits the characteristics of the quasi-nonvolatile memory device due to the positive feedback loop mechanism and the $p^+$-n-p-$n^+$ structure.

Therefore, the present disclosure can implement a binarized neural network circuitry that can be utilized in next-generation artificial intelligence computing technology by reducing standby power through the utilization of the excellent memory characteristics of the quasi-nonvolatile memory device and increasing computational efficiency with low power consumption through excellent switching characteristics.

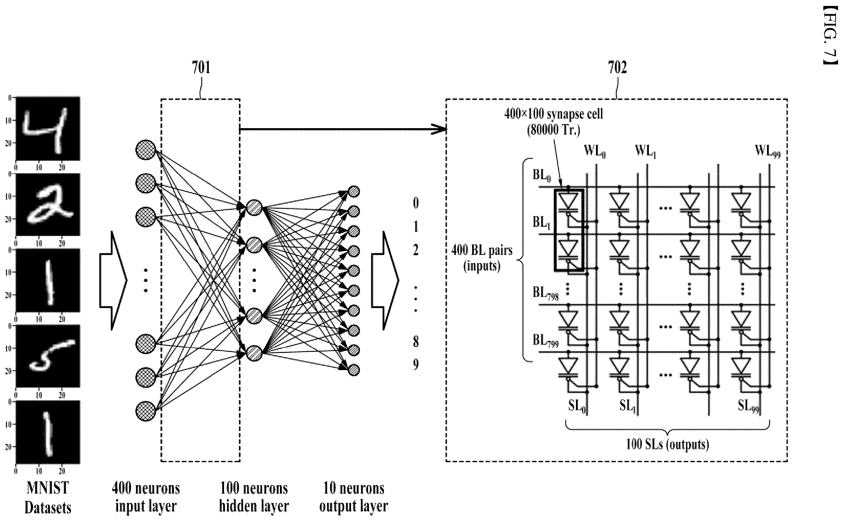

FIG. 7 illustrates the simulation structure of the binarized neural network circuitry according to an embodiment of the present disclosure using a quasi-nonvolatile memory device.

FIG. 7 exemplifies the simulation structure of the binarized neural network circuitry according to an embodiment of the present disclosure using a quasi-nonvolatile memory device.

Referring to FIG. 7, a binarized neural network circuitry structure 700 shows that the binarized neural network circuitry of the present disclosure can be utilized to perform MNIST image recognition simulation using open source code to investigate and evaluate the validity of a binarized neural network.

The binarized neural network circuitry structure 700 includes a binarized neural network circuitry 701 illustrated in FIG. 3.

The binarized neural network circuitry structure 700 has a multilayer perceptron structure for MNIST recognition simulation, and a synapse array present between an input layer, composed of 400 neurons that receive pixel data of the MNIST image, and a hidden layer, composed of 100 neurons, is composed of a total of 80,000 (400x100 synaptic cells) quasi-nonvolatile memory devices.

Each neuron in the output layer corresponds to an MNIST image recognition result, and the synaptic array between the input layer and the hidden layer receives MNIST image data through 400 BL pairs and sends the matrix MAC result to the hidden layer through 100 SLs.

Each neuron layer may be the binarized neural network circuitry 701, and the synapse arrangement between the hidden layer and the output layer may be implemented similarly to the arrangement mentioned above.

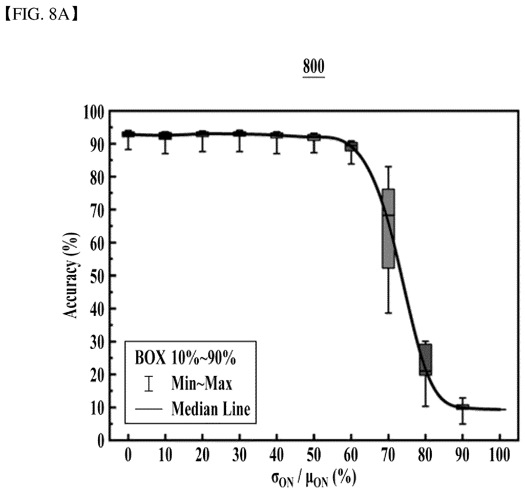

Simulation results based on the binarized neural network circuitry structure 700 are supplemented with FIGS. 8A to 8C.

FIGS. 8A to 8C illustrate simulation results of the binarized neural network circuitry according to an embodiment of the present disclosure using a quasi-nonvolatile memory device.

Referring to FIG. 8A, Graph 800 shows the effect of component-based nonvolatile memory elements on the recognition accuracy of MNIST images as a conductance standard deviation $\sigma_{ON}/\mu_{ON}$.

Measurement data obtained from the device, including conductance and operating voltage, were used as simulation parameters.

For $\sigma_{ON}/\mu_{ON}$ less than 60%, the median recognition accuracy remained at 90% or more, whereas for $\sigma_{ON}/\mu_{ON}$ equal to or greater than 60%, the recognition accuracy decreased significantly.

The accuracy degradation for high $\sigma_{ON}/\mu_{ON}$ is due to the increased error probability when comparing $I_{SL}$ and $I_{ref}$ due to the parallelized readout mechanism of the binarized neural network circuitry.

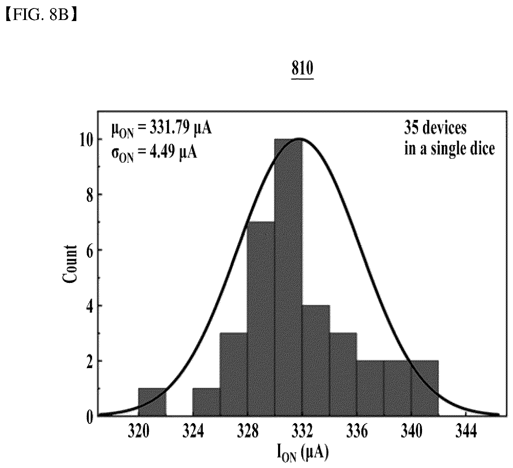

Referring to FIG. 8B, Graph 810 shows that the quasi-nonvolatile memory device demonstrates excellent reproducibility with a low $\sigma_{ON}/\mu_{ON}$ of 1.35% across 35 devices with the same structure on a single die.

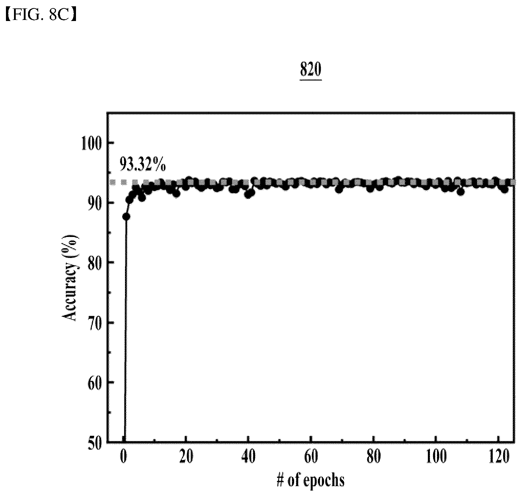

Referring to FIG. 8C, Graph 820 shows the recognition accuracy of the MINIST image of the binarized neural network circuitry.

The MINIST image recognition accuracy for 125 training epochs of the binarized neural network circuitry is shown.

For each epoch, 8,000 training data sets (1 million MNIST images in total), 60,000 training labels, and 10,000 test labels are applied.

Due to the excellent bistability characteristics and the high uniformity and reproducibility of the quasi-nonvolatile memory device, the binarized neural network circuitry achieves a high accuracy of about 93.32%.

As a result, the high reliability, reproducibility and uniformity of the quasi-nonvolatile memory device can be used to implement a compact binarized neural network circuitry without compromising accuracy.

Therefore, the present disclosure can implement a binarized neural network circuitry that allows a memory array composed of the quasi-nonvolatile memory device based on the positive feedback loop to perform the activation function of a neuron circuit on its own and has excellent uniformity and stability.

The present disclosure can implement a binarized neural network that can perform both memory functions and logical operation functions on a memory array consisting of quasi-nonvolatile memory devices that perform memory and switching functions in a single device based on a positive feedback loop.

The present disclosure can implement a logically operatable binarized neural network with excellent uniformity and stability due to almost no characteristic deviation by using a quasi-nonvolatile memory device applicable to a CMOS process as a synaptic device.

The present disclosure can implement a binarized neural network circuitry that allows a memory array composed of the quasi-nonvolatile memory device based on the positive feedback loop to perform the activation function of a neuron circuit on its own and has excellent uniformity and stability.

The present disclosure can implement a binarized neural network circuitry that can be utilized in next-generation artificial intelligence computing technology by reducing standby power through the utilization of the excellent memory characteristics of the quasi-nonvolatile memory device and increasing computational efficiency with low power consumption through excellent switching characteristics.

In the aforementioned embodiments, constituents of the present disclosure were expressed in a singular or plural form depending upon embodiments thereof.

However, the singular or plural expressions should be understood to be suitably selected depending upon a suggested situation for convenience of description, and the aforementioned embodiments should be understood not to be limited to the disclosed singular or plural forms. In other words, it should be understood that plural constituents may be a singular constituent or a singular constituent may be plural constituents.

While the embodiments of the present disclosure have been described, those skilled in the art will appreciate that many modifications and changes can be made to the present disclosure without departing from the spirit and essential characteristics of the present disclosure.

Therefore, it should be understood that there is no intent to limit the disclosure to the embodiments disclosed, rather, the disclosure is to cover all modifications, equivalents, and alternatives falling within the spirit and scope of the disclosure as defined by the claims.

[Description of Symbols]

| 300: | binarized neural network circuitry | 301: | synaptic cell |
| 302: | input line processor | 303: | weight line processor |

**Claims**

1. A binarized neural network circuitry, wherein a diode structure is positioned in a channel region between a drain terminal and a source terminal, a gate terminal is positioned on the diode structure, an operation state is determined by occurrence of a latch-up or latch-down phenomenon due to a positive feedback loop in the channel region based on different voltages applied to the drain terminal and the gate terminal, respectively, and a plurality of quasi-nonvolatile memory devices that implement memory characteristics of remembering a memory state are comprised as holes or electrons in a potential well in the channel region due to the positive feedback loop are accumulated, and
the plural quasi-nonvolatile memory devices are a pair of two quasi-nonvolatile memory devices that operate as a single synaptic cell and are connected in parallel to form an array circuit, memory states of the two quasi-nonvolatile memory devices are determined and stored based on an input line applied from an input line processor connected to the array circuit and a weight update signal applied from a synaptic line processor connected to the array circuit, and a MAC (multiply-accumulate) operation result is output using a combination of the memory states.

2. The binarized neural network circuitry according to claim 1, wherein the synaptic cell remembers a synaptic weight through the combination of the operation states of the two quasi-nonvolatile memory devices, and when the input line is applied, it performs an XNOR logic operation according to the input line and the synaptic weight and outputs an XNOR logic operation result.

3. The binarized neural network circuitry according to claim 1, wherein each of the two quasi-nonvolatile memory devices is determined to be in one of a first operation state and a second operation state based on the input line, and is determined to be in the first operation state when the input line is higher than a reference voltage $V_{High}$ and to be in the second operation state when the input line is lower than the reference voltage $V_{Low}$.

4. The binarized neural network circuitry according to claim 3, wherein when the input line is a negative value, an upper quasi-nonvolatile memory device among the two quasi-nonvolatile memory devices is applied with the voltage lower than the reference, and a lower quasi-nonvolatile memory device thereamong is applied with the voltage higher than the reference, and

when the input line is a positive value, the upper quasi-nonvolatile memory device is applied with the voltage higher than the reference, and the lower quasi-nonvolatile memory device is applied with the voltage lower than the reference.

5. The binarized neural network circuitry according to claim 1, wherein each of the two quasi-nonvolatile memory devices is determined to be in one of a first operation state and a second operation state based on the input line, and is determined to be in the first operation state when the input line is higher than the reference voltage $V_{High}$ and to be in the second operation state when the input line is lower than the reference voltage $V_{Low}$, and a synaptic weight is determined as one of a negative value and a positive value based on a combination of the first operation state and the second operation state.

6. The binarized neural network circuitry according to claim 5, wherein the synaptic cell determines a synaptic weight as the positive value when the first quasi-nonvolatile memory device among the two quasi-nonvolatile memory devices is in the second operation state and the second quasi-nonvolatile memory device thereamong is in the first operation state, determines a synaptic weight as the negative value when the first quasi-nonvolatile memory device is in the first operation state and the second quasi-nonvolatile memory device is in the second operation state, determines a synaptic weight as the negative value when the first quasi-nonvolatile memory device is in the second operation state and the second quasi-nonvolatile memory device is in the first operation state, and determines a synaptic weight as the positive value when the first quasi-nonvolatile memory device is in the first operation state and the second quasi-nonvolatile memory device is in the second operation state.

7. The binarized neural network circuitry according to claim 6, wherein a plurality of synaptic cells are configured based on the plural quasi-nonvolatile memory devices, the plural synaptic cells are connected in parallel to provide a synaptic weight matrix composed of synaptic weights stored in each thereof, and a vector-matrix multiplication operation between the provided synaptic weight matrix and a matrix of input vectors based on an input line to determine the synaptic weights is performed to output an XNOR binary operation result.

8. The binarized neural network circuitry according to claim 7, wherein when the synaptic cells are composed of 2 rows and 2 columns, a logic state is output as "0" if a current detected in relation to the output XNOR binary operation result is adjacent to a reference current, the logic state is output as "+2" if the detected current is twice the reference current, and the logic state is output as "-2" if the reference current is adjacent to "0".

9. The binarized neural network circuitry according to claim 1, wherein the quasi-nonvolatile memory device receives a drain voltage of the drain terminal as the input line, generates a latch-up phenomenon due to the positive feedback loop as the applied input line increases in a positive direction, and has one of two memory states for the channel region, the input line where the latch-up phenomenon occurs is controlled as a gate voltage of the gate terminal is applied as the weight update signal, and a synaptic state related to one of the memory states is updated according to the input line and the application of the weight update signal, and the MAC operation function is performed according to the synaptic weight.

10. The binarized neural network circuitry according to claim 1, wherein the memory array connects the drain terminal, the gate terminal and the source terminal in parallel in the plural quasi-nonvolatile memory devices to form an input line, a weight line and an output line, respectively,

the input line is arranged perpendicular to the weight line and the output line, and
the weight line and the output line are arranged in parallel.

11. The binarized neural network circuitry according to claim 10, wherein the input line receives the input line from an input line processor,

the weight line receives the weight update signal from a weight line processor, and
the output line is connected to a current sensing processor, and outputs the MAC operation result based on the input line and the weight update signal to a next artificial neural network stage through the current sensing processor.

12. The binarized neural network circuitry according to claim 1, wherein the quasi-nonvolatile memory device comprises one of a quasi-nonvolatile memory device using a single gate, a quasi-nonvolatile memory device using a double gate, and a quasi-nonvolatile memory device using a triple gate.

【FIG. 1A】

| 100 | 110 |
|---|---|

【FIG. 1B】

| 120 | 130 |
|---|---|

【FIG. 1C】

| 140 | 150 |
|---|---|

145    146

144

p⁺      i      n⁺

141    142    143

151

153    154
152

【FIG. 1D】

【FIG. 2A】

【FIG. 2B】

【FIG. 2C】

【FIG. 2D】

230

【FIG. 3】

EP 4 621 782 A1

【FIG. 4A】

【FIG. 4B】

410

| | IN | W | OUT |
|---|---|---|---|
| 411 | -1 | -1 | +1 |
| 412 | -1 | +1 | -1 |
| 413 | +1 | -1 | -1 |
| 414 | +1 | +1 | +1 |

【FIG. 5A】

【FIG. 5B】

510

【FIG. 5C】

EP 4 621 782 A1

【FIG. 6】

29

【FIG. 7】

【FIG. 8A】

800

【FIG. 8B】

【FIG. 8C】

**EUROPEAN SEARCH REPORT**

Application Number

EP 25 16 5156

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | US 2025/077853 A1 (KIM SANG SIG [KR] ET AL) 6 March 2025 (2025-03-06)<br>* paragraph [0062] - paragraph [0065]; figure 1A *<br>* paragraph [0104] - paragraph [0121]; figure 4 *<br>* line 141 - line 147; figure 5B *<br>----- | 1-12 | INV.<br>G11C11/39<br>G06N3/063<br>G11C11/54 |
| A | KIM HYEONGSU ET AL: "Variation-Tolerant Capacitive Array for Binarized Neural Network",<br>IEEE ELECTRON DEVICE LETTERS, IEEE, USA, vol. 43, no. 3,<br>14 January 2022 (2022-01-14), pages 478-481, XP011901266,<br>ISSN: 0741-3106, DOI: 10.1109/LED.2022.3143140<br>[retrieved on 2022-02-23]<br>* the whole document *<br>----- | 1-12 | |
| A | US 2012/228629 A1 (NEMATI FARID [US] ET AL) 13 September 2012 (2012-09-13)<br>* paragraph [0035] - paragraph [0054]; figure 1 *<br>* paragraph [0^56] - paragraph [0057]; figure 3 *<br>----- | 1-12 | **TECHNICAL FIELDS SEARCHED (IPC)**<br><br>G11C<br>G06N |

The present search report has been drawn up for all claims

| Place of search | Date of completion of the search | Examiner |
|---|---|---|
| The Hague | 22 July 2025 | Knack, Steffen |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 16 5156

This annex lists the patent family members relating to the patent documents cited in the above-mentioned European search report.
The members are as contained in the European Patent Office EDP file on
The European Patent Office is in no way liable for these particulars which are merely given for the purpose of information.

22-07-2025

| Patent document cited in search report | Publication date | Patent family member(s) | Publication date |
|---|---|---|---|
| US 2025077853 A1 | 06-03-2025 | DE 102023213345 A1 | 06-03-2025 |
| | | JP 7620348 B1 | 23-01-2025 |
| | | JP 2025035998 A | 14-03-2025 |
| | | KR 20250032103 A | 07-03-2025 |
| | | US 2025077853 A1 | 06-03-2025 |
| US 2012228629 A1 | 13-09-2012 | TW 201241928 A | 16-10-2012 |
| | | US 2012228629 A1 | 13-09-2012 |
| | | US 2013314986 A1 | 28-11-2013 |
| | | US 2016078917 A1 | 17-03-2016 |
| | | WO 2012121845 A2 | 13-09-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240039833
- KR 1020230053195
- KR 1020220110774
- KR 1020230020840
- KR 1020220107808